# EUROPÄISCHE PATENTSCHRIFT

(11) **EP 3 471 904 B1**
(45) Veröffentlichungstag und Bekanntmachung des Hinweises auf die Patenterteilung: **07.10.2020**
(21) Anmeldenummer: 17730367.4
(22) Anmeldetag: 11.05.2017
(51) Int. Cl.: B65B 41/16, B65B 47/06

(54) **VERFAHREN ZUR HERSTELLUNG EINES BEHÄLTERS**
METHOD FOR PRODUCING A CONTAINER
PROCÉDÉ DE FABRICATION D'UN RÉCIPIENT

(30) Priorität: 21.06.2016 DE 102016211018
(43) Veröffentlichungstag der Anmeldung: 24.04.2019
(73) Patentinhaber: Continental Teves AG & Co. OHG, 60488 Frankfurt am Main (DE)
(72) Erfinder: GOLL, Manfred, 63695 Glauburg (DE); HAVERKAMP, Martin, 60385 Frankfurt (DE); STICKSEL, Gerhard, 63571Gelnhausen-Haitz (DE)
(86) Internationale Anmeldenummer: PCT/DE2017/200042
(87) Internationale Veröffentlichungsnummer: WO 2017/220090

(56) Entgegenhaltungen:
- EP-A1- 2 860 119
- FR-A1- 2 846 476
- US-A1- 2015 373 867

## Beschreibung

### TECHNISCHES GEBIET

Die vorliegende Erfindung betrifft ein Verfahren zur Herstellung eines Behälters, insbesondere eines Behälters für elektronische Module.

### TECHNISCHER HINTERGRUND

Elektronische Module, beispielsweise bestückte Leiterplatten, werden üblicherweise in separat dafür hergestellte Behälter, in der Regel zweiteilig, eingelegt und gesichert. Danach werden die Behälter verschlossen.

Üblicherweise werden zur Herstellung eines derartigen Behälters die Teile eines Behälters aus Kunststoff im Spritzgießverfahren hergestellt, während die metallischen Teile des Behälters im Sinterguß bzw. in Präge-Stanztechnik hergestellt werden. Dadurch wird der Behälter in einer Mehrzahl von unterschiedlichen Herstellungsstationen hergestellt, wodurch die Herstellungskosten des Behälters steigen.

Aus der US 20150373867 A1 geht ein Verfahren zum Bilden einer Motorsteuereinheit hervor, wobei ein Metallgehäuse mit einem ersten Gehäuseabschnitt, einen Biegeabschnitt, der einheitlich mit dem ersten Gehäuseabschnitt ausgebildet ist, und einen zweiten Gehäuseabschnitt, der einstückig mit dem Biegeabschnitt ausgebildet ist, gestanzt wird und der Biegeabschnitt um den ersten und den zweiten Gehäuseabschnitt miteinander in Kontakt zu bringen und einen inneren Hohlraum zwischen dem ersten und dem zweiten Gehäuseabschnitt zu definieren, gebogen wird.

Die EP 2 860 119 A1 betrifft eine Tiefziehverpackungsmaschine mit einer ersten Formstation zum Formen einer Mulde in eine Unterfolie und einer zweiten Formstation zum Formen eines Deckels in eine Oberfolie, sowie eine Siegelstation zum Versiegeln von Mulden mit Deckeln.

### BESCHREIBUNG DER ERFINDUNG

Es ist daher die Aufgabe der vorliegenden Erfindung, ein effizienteres Verfahren zur Herstellung eines Behälters, insbesondere eines Behälters für elektronische Module, zur Verfügung zu stellen.

Diese Aufgabe wird durch die Gegenstände der unabhängigen Ansprüche gelöst. Bevorzugte Ausführungsformen der Erfindung sind Gegenstand der abhängigen Ansprüche, der Beschreibung sowie der Figuren.

Die Erfindung basiert auf der Erkenntnis, dass die obige Aufgabe durch eine direkte Herstellung eines Behälters mit der Montage der elektronischen Module in dem Behälter, unter Verwendung einer Herstellungsvorrichtung, gelöst werden kann.

Gemäß einem ersten Aspekt wird die Aufgabe durch ein Verfahren zur Herstellung eines Behälters mit einem Oberteil, einem Unterteil und einem Aufnahmeelement gelöst. Das Verfahren weist zumindest die folgenden Schritte auf: Erstellen des Unterteils aus einem ersten Edukt in einem ersten Bearbeitungsbereich einer Bearbeitungsvorrichtung, Erstellen des Oberteils aus einem zweiten Edukt in einem zweiten Bearbeitungsbereich der Bearbeitungsvorrichtung, Führen des Aufnahmeelements in den ersten Bearbeitungsbereich der Bearbeitungsvorrichtung, Aufnehmen des Aufnahmeelements durch das Unterteil in dem ersten Bearbeitungsbereich der Bearbeitungsvorrichtung, Führen des Oberteils von dem zweiten Bearbeitungsbereich der Bearbeitungsvorrichtung in den ersten Bearbeitungsbereich der Bearbeitungsvorrichtung und Zusammenfügen von dem Oberteil und dem Unterteil zu dem Behälter in dem ersten Bearbeitungsbereich der Bearbeitungsvorrichtung. Erfindungsgemäß ist das Aufnahmeelement ein elektrisches aktives Element, wobei das Verfahren ferner den Schritt des elektrischen Kontaktierens des durch das Unterteil aufgenommenen Aufnahmeelements aufweist.

Dadurch wird beispielsweise der technische Vorteil erreicht, dass das Oberteil und das Unterteil des Behälters in derselben Herstellungsvorrichtung hergestellt werden können.

Dadurch wird weiterhin der technische Vorteil erreicht, dass für die Herstellung des Behälters, insbesondere für das Fertigungs- und Montagekonzept, nur geringe Kosten entstehen.

Dadurch wird weiterhin der technische Vorteil erreicht, dass das Aufnahmeelement in derselben Herstellungsvorrichtung, in der das Oberteil und das Unterteil des Behälters hergestellt werden, verbaut und geprüft werden kann. Das Aufnahmeelement kann ein vorgefertigtes elektronisches Modul sein.

Gemäß einer bevorzugten Ausführungsform erfolgt das Erstellen des Unterteils aus einem ersten Edukt und/oder das Erstellen des Oberteils aus einem zweiten Edukt durch Umformen des ersten Edukts und/oder des zweiten Edukts.

Gemäß einer weiteren bevorzugten Ausführungsform umfasst das Umformen ein Tiefziehen.

Gemäß einer weiteren bevorzugten Ausführungsform umfasst das Umformen ein Abrollen des in aufgerollter Form bereitgestellten ersten Edukts und/oder zweiten Edukts.

Dadurch wird beispielsweise der technische Vorteil erreicht, dass verringerte Werkzeugkosten für die Teile des Behälters bei der Fertigung durch ein Tiefziehen entstehen.

Dadurch wird weiter der technische Vorteil erreicht, dass die im Automobilbau bevorzugten Teile des Behälters durch ein Folien-Tiefziehen hergestellt werden können. Weiterhin können auch metallische Teile des Behälters mit kleiner Dicke im Metallfolien-Tiefziehen von der Rolle hergestellt werden.

Gemäß einer vorteilhaften Ausführungsform erfolgt das Erstellen des Unterteils aus einem ersten Edukt und/oder das Erstellen des Oberteils aus einem zweiten Edukt durch Stanzen.

Gemäß einer weiteren bevorzugten Ausführungsform ist das Aufnahmeelement eine bestückte Leiterplatte.

Gemäß einer weiteren bevorzugten Ausführungsform umfasst das Verfahren den Schritt des elektrischen Prüfens der Funktionsfähigkeit des elektrisch kontaktierten Aufnahmeelements.

Gemäß einer weiteren bevorzugten Ausführungsform umfasst das Verfahren den Schritt des Bereitstellens von Kunststoff als erstes Edukt und/oder als zweites Edukt.

Gemäß einer weiteren bevorzugten Ausführungsform entspricht das erste Edukt dem zweiten Edukt.

Gemäß einer weiteren bevorzugten Ausführungsform erfolgt das Erstellen des Oberteils in dem zweiten Bearbeitungsbereich der Bearbeitungsvorrichtung in unmittelbarer Umgebung, insbesondere angrenzend zu dem Erstellen des Unterteils in dem ersten Bearbeitungsbereich der Bearbeitungsvorrichtung.

Gemäß einer weiteren bevorzugten Ausführungsform wird das Führen des Oberteils von dem zweiten Bearbeitungsbereich in den ersten Bearbeitungsbereich automatisiert durchgeführt.

Gemäß einer weiteren bevorzugten Ausführungsform wird das Aufnehmen des Aufnahmeelements durch das Unterteil in dem ersten Bearbeitungsbereich der Bearbeitungsvorrichtung vor dem Zusammenfügen von dem Oberteil und dem Unterteil zu dem Behälter in dem ersten Bearbeitungsbereich der Bearbeitungsvorrichtung durchgeführt.

Gemäß einer vorteilhaften Ausführungsform erfolgt das Aufnehmen des Aufnahmeelements durch das Unterteil durch Verschrauben und/oder durch Warmverformung eines Verbindungselements.

Gemäß einem zweiten Aspekt wird die Aufgabe durch einen Behälter mit einem Oberteil, einem Unterteil und einem Aufnahmeelement, bereitgestellt gemäß eines Verfahrens nach mindestens einem der vorherigen bevorzugten Ausführungsformen, gelöst.

### BESCHREIBUNG DER FIGUREN

Weitere Ausführungsbeispiele werden bezugnehmend auf die beiliegenden Figuren näher erläutert:
Fig. 1 zeigt eine schematische Darstellung eines Verfahrens zur Herstellung eines Behälters.
Fig. 2 zeigt eine weitere schematische Darstellung eines Verfahrens zur Herstellung eines Behälters.
Fig. 3 zeigt Teile eines Behälters.
Fig. 4 zeigt Teile eines Behälters.
Fig. 5 zeigt Teile eines Behälters.
Fig. 6 zeigt einen Behälter.
Fig. 7 zeigt einen Behälter.
Fig. 8 zeigt eine schematische Darstellung eines Behälters.

### DETAILLIERTE BESCHREIBUNG DER FIGUREN

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen, wie in den beigefügten Ansprüchen definiert ist.

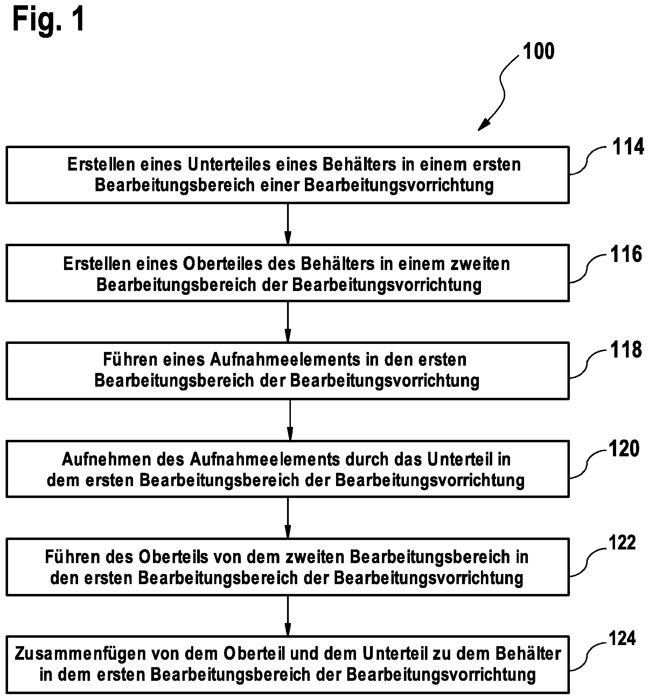

Wenngleich ein bestimmtes Merkmal oder ein bestimmter Aspekt einer Ausführungsform bezüglich nur einer von mehreren Implementierungen offenbart worden sein mag, kann außerdem ein derartiges Merkmal oder ein derartiger Aspekt mit einem oder mehreren anderen Merkmalen oder Aspekten der anderen Implementierungen kombiniert werden, wie für eine gegebene oder bestimmte Anwendung erwünscht und vorteilhaft sein kann. Weiterhin sollen in dem Ausmaß, in dem die Ausdrücke "enthalten", "haben", "mit" oder andere Varianten davon entweder in der ausführlichen Beschreibung oder den Ansprüchen verwendet werden, solche Ausdrücke auf eine Weise ähnlich dem Ausdruck "umfassen" einschließend sein. Die Ausdrücke "gekoppelt" und "verbunden" können zusammen mit Ableitungen davon verwendet worden sein. Es versteht sich, dass derartige Ausdrücke dazu verwendet werden, um anzugeben, dass zwei Elemente unabhängig davon miteinander kooperieren oder interagieren, ob sie in direktem physischem oder elektrischem Kontakt stehen oder nicht in direktem Kontakt miteinander stehen. Außerdem ist der Ausdruck "beispielhaft" lediglich als ein Beispiel aufzufassen anstatt der Bezeichnung für das Beste oder Optimale. Die folgende Beschreibung ist deshalb nicht in einem einschränkenden Sinne zu verstehen. Fig. 1 zeigt eine schematische Darstellung eines Verfahrens 100 zur Herstellung eines Behälters 102. In dieser Ausführungsform umfasst das Verfahren 100 zumindest die folgenden Schritte: Erstellen 114 eines Unterteiles 110 des Behälters 102 in einem ersten Bearbeitungsbereich 115a einer Bearbeitungsvorrichtung 115, Erstellen 116 eines Oberteiles 108 des Behälters 102 in einem zweiten Bearbeitungsbereich 115b der Bearbeitungsvorrichtung 115, Führen 118 eines Aufnahmeelements 112 in den ersten Bearbeitungsbereich 115a der Bearbeitungsvorrichtung 115, Aufnehmen 120 des Aufnahmeelements 112 durch das Unterteil 110 in dem ersten Bearbeitungsbereich 115a der Bearbeitungsvorrichtung 115, Führen 122 des Oberteils 108 von dem zweitem Bearbeitungsbereich 115b in den ersten Bearbeitungsbereich 115a der Bearbeitungsvorrichtung 115 und Zusammenfügen 124 von dem Oberteil 108 und dem Unterteil 110 zu dem Behälter 102 in dem ersten Bearbeitungsbereich 115a der Bearbeitungsvorrichtung 115.

Das Verfahren 100 hat beispielsweise den technischen Vorteil, dass das Oberteil 108 und das Unterteil 110 des Behälters 102 in derselben Bearbeitungsvorrichtung 115 hergestellt werden können.

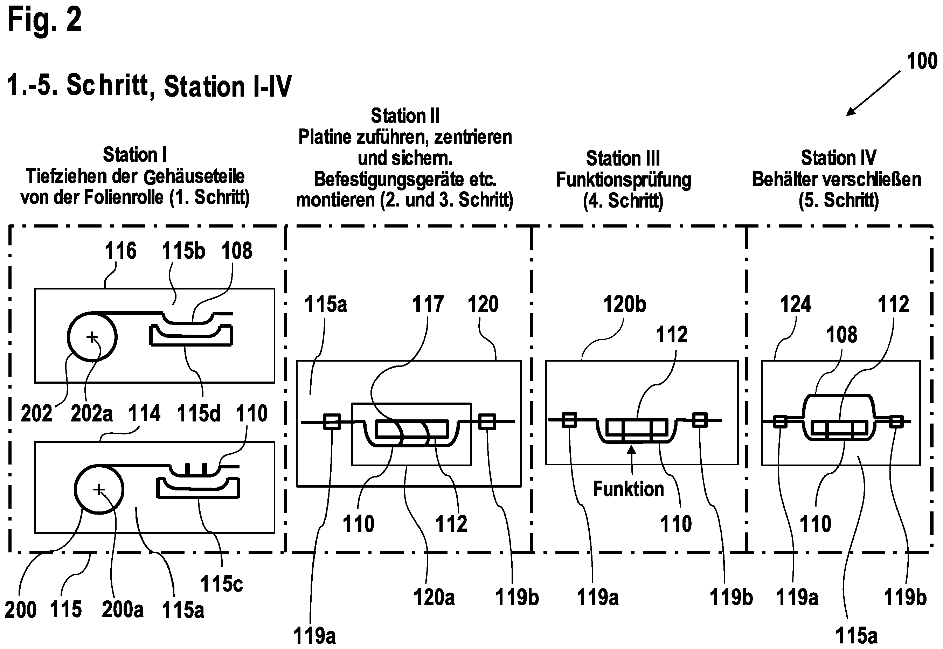

Fig. 2 zeigt eine weitere schematische Darstellung eines Verfahrens 100 zur Herstellung eines Behälters 102. In diesem Ausführungsbeispiel umfasst das Verfahren 100 vier Stationen sowie fünf Schritte zur Herstellung des Behälters 102.

In Station I (Schritt 1) werden das Unterteil 110 und das Oberteil 108 des Behälters 102 hergestellt. Das Unterteil 110 kann aus einem ersten Edukt 200 in einem ersten Bearbeitungsbereich 115a einer Bearbeitungsvorrichtung 115 erstellt 114 werden. Das Oberteil 108 kann aus einem zweiten Edukt 202 in einem zweiten Bearbeitungsbereich 115b der Bearbeitungsvorrichtung 115 erstellt 116 werden. Das Unterteil 110 und das Oberteil 108 können durch Umformen in einem Folien-Tiefziehverfahren des entsprechenden Edukts, bzw. 200 und 202, über Vakuum (gegebenenfalls mit Hilfe von Überdruck), hergestellt werden, wobei die Edukte 200 und 202 auf einer Rolle bzw. 200a und 202a aufgerollt sind. Die Tiefziehwerkzeuge 115c und 115d können in die gesamte Bearbeitungsvorrichtung 115 integriert sein.

In Station II, im Schritt 2, kann das Aufnahmeelement 112 in den ersten Bearbeitungsbereich 115a der Bearbeitungsvorrichtung 115 geführt 118 werden und es kann durch das Unterteil 110 in dem ersten Bearbeitungsbereich 115a aufgenommen 120 werden. Das Aufnahmeelement 112 kann ein elektrisch aktives Element, insbesondere eine komplett bestückt Leiterplatte, sein und es kann automatisch durch das Unterteil 110 aufgenommen 120 werden. Das Aufnahmeelement 112 kann beim Aufnehmen 120 über gehäuseseitige Pins 117 zentriert werden.

In Station II, im Schritt 3, kann das Aufnahmeelement 112, beispielsweise eine Leiterplatte, niedergehalten und fixiert werden. Dies kann durch Warmverformung der gehäuseseitigen Zentrierpins 117 erfolgen, wahlweise auch durch Verschrauben mit Kunststoff-Schrauben (nicht dargestellt). Die Schritte 2 und 3 können auf derselben Station (II) der Bearbeitungsvorrichtung 115 durchgeführt werden.

Zusätzlich kann das Verfahren 100 den Schritt des elektrischen Kontaktierens 120a des durch das Unterteil 110 aufgenommenen Aufnahmeelements 112 umfassen. Weiterhin können metallische Befestigungsteile 119a und 119b in das Oberteil 108 oder in das Unterteil 110 montiert, bevorzugt genietet, werden.

In Station III (Schritt 4) kann die Funktionsfähigkeit des elektrisch kontaktierten Aufnahmeelements 112, beispielsweise einer bestückten Leiterplatte, geprüft 120b werden.

In Station IV (Schritt 5) kann das Oberteil 108 von dem zweiten Bearbeitungsbereich 115b der Bearbeitungsvorrichtung 115 in den ersten Bearbeitungsbereich 115a der Bearbeitungsvorrichtung 115 geführt 122 werden. Weiterhin können das Oberteil 108 und das Unterteil 110 zu dem Behälter 102 in dem ersten Bearbeitungsbereich 115a der Bearbeitungsvorrichtung 115 zusammengefügt 124 werden. Das Oberteil 108, beispielsweise ein Deckel, kann automatisch zugeführt werden und punktuell bzw. flächig mit dem Unterteil 110 verschweißt werden. Gegebenenfalls kann das Oberteil 108, je nach Funktionsanforderung, auch verklipst werden.

Mit der Herstellung des Oberteils 108 und des Unterteils 101 im Tiefziehverfahren von den Rollen 200a und 202a wird die verkettete Fertigung des Behälters 102 auf einer Bearbeitungsvorrichtung 115 ermöglicht.

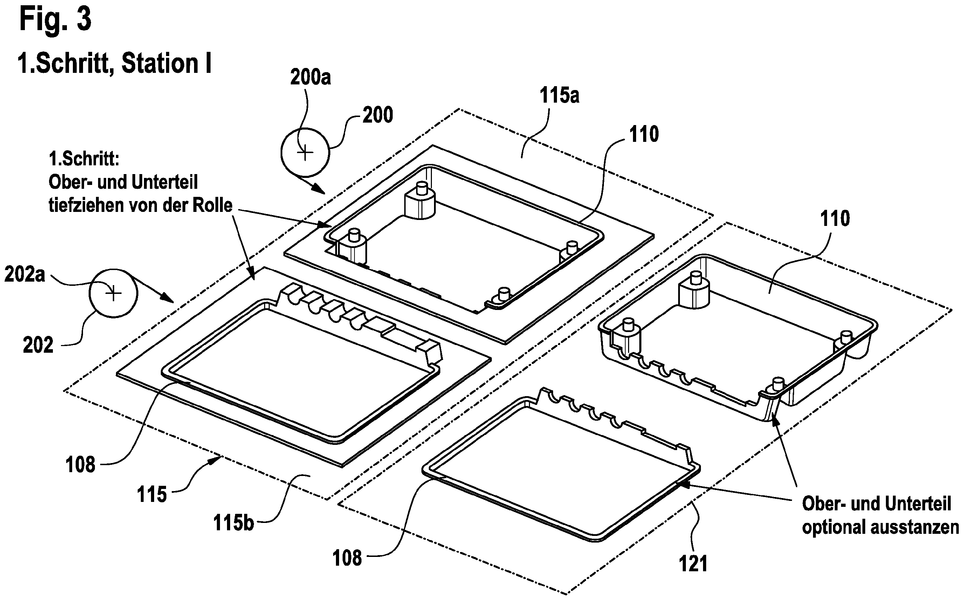

Fig. 3 zeigt Teile eines Behälters 102, die im ersten Schritt der Station I gemäß der Beschreibung von Fig. 2 erstellt werden können. Im ersten Schritt der Station I können das Oberteil 108 und das Unterteil 110 des Behälters 102 durch ein Tiefziehverfahren erstellt werden. Das Unterteil 110 kann von einer Rolle 200a, die ein erstes Edukt 200 umfasst, in einem ersten Bearbeitungsbereich 115a, erstellt werden. Das Oberteil 108 kann von einer Rolle 202a, die ein zweites Edukt 202 umfasst, in einem zweiten Bearbeitungsbereich 115b, erstellt werden. Die Bearbeitungsvorrichtung 115 kann den ersten Bearbeitungsbereich 115a und den zweiten Bearbeitungsbereich 115b umfassen. In Fig. 3 wird ein optionaler Schritt der Station I gezeigt, der das Ausstanzen 121 des Oberteils 108 und des Unterteils 110 des Behälters 102 umfasst.

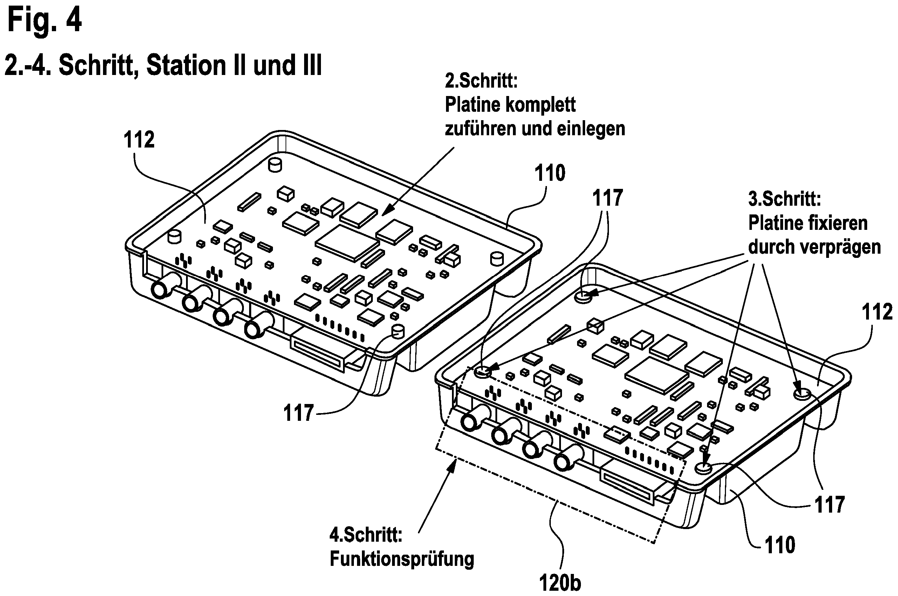

Fig. 4 zeigt Teile eines Behälters 102. In Fig. 4 werden Teile des Behälters 102 gezeigt, die in Station II und Station III gemäß der Beschreibung von Fig. 2 erstellt werden können. In diesem Ausführungsbeispiel kann das Aufnahmeelement 112, beispielsweise eine Platine, in das Unterteil 110 des Behälters 102 geführt 118 und eingelegt werden (Schritt 2 gemäß der Beschreibung von Fig. 2). Die Platine kann auch durch Pins 117 fixiert werden (Schritt 3 gemäß der Beschreibung von Fig. 2) . Weiterhin kann die Funktion der Platine geprüft 120b werden (Schritt 4 gemäß der Beschreibung von Fig. 2).

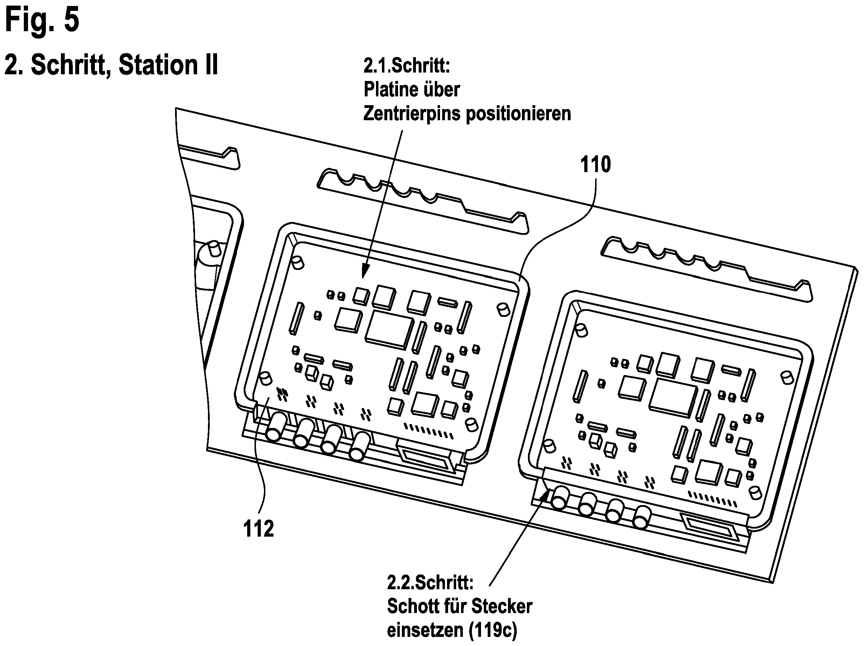

Fig. 5 zeigt Teile eines Behälters 102. In diesem Ausführungsbeispiel wird der Schritt 2 der Station II gemäß der Beschreibung von Fig. 2 erläutert. Für entsprechende Steckerausführungen auf dem Aufnahmeelement 112, beispielsweise auf einer bestückten Leiterplatte, kann gegebenenfalls ein Zwischenstück "Schott" aus einer Folie gestanzt werden und es kann in dem Unterteil 110 des Behälters 102 geklipst 119c oder eingesetzt werden.

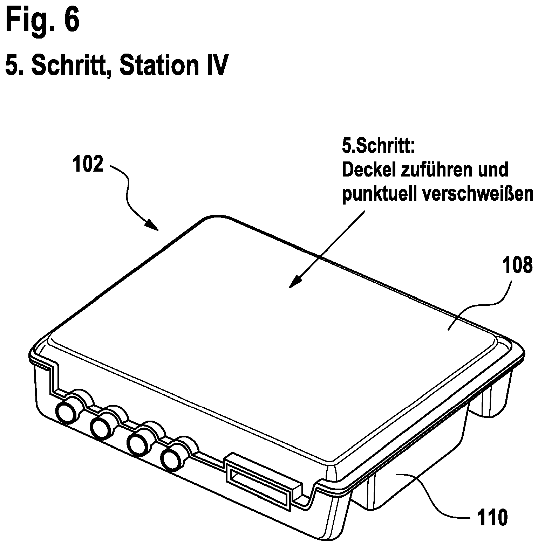

Fig. 6 zeigt einen Behälter 102. Der Behälter 102 umfasst das Oberteil 108, beispielsweise einen Deckel, und das Unterteil 110. In diesem Ausführungsbeispiel wird der Schritt 5 der Station IV gemäß der Beschreibung von Fig. 2 erläutert. Der Deckel kann zugeführt werden und dann punktuell verschweißt werden.

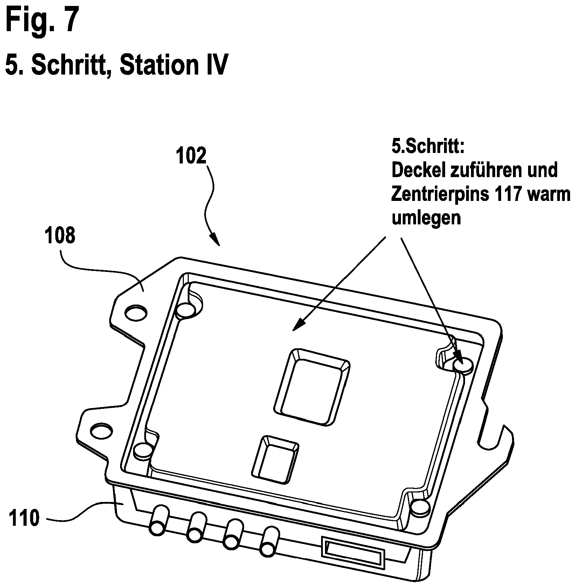

Fig. 7 zeigt einen Behälter 102. Der Behälter 102 umfasst das Oberteil 108, beispielsweise einen Deckel, das Unterteil 110 und das Aufnahmeelement 112 (nicht gezeigt in Fig. 7). In diesem Ausführungsbeispiel wird der Schritt 5 der Station IV gemäß der Beschreibung von Fig. 2 erläutert. In diesem Ausführungsbeispiel kann das Oberteil 108 das Aufnahmeelement 112, beispielsweise eine bestückte Platine, niederhalten und kann das Oberteil 108 durch Warmumformen der Zentrierpins 117, wahlweise durch Verschrauben mit Kunststoffschrauben (nicht dargestellt), mit dem Unterteil 110 zur fertigen Einheit verbunden werden. Das Oberteil 108 und das Unterteil 110 können, je nach Anforderung, aus einer Metallfolie tiefgezogen werden.

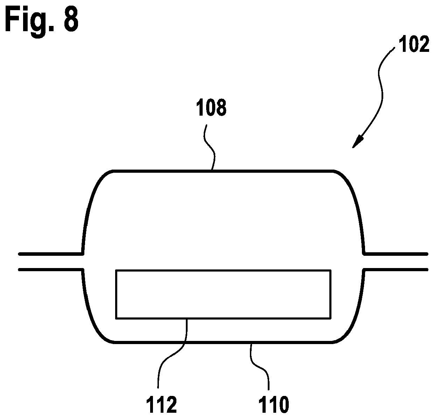

Fig. 8 zeigt eine schematische Darstellung eines Behälters 102. Der Behälter 102 umfasst das Oberteil 108, das Unterteil 110 und das Aufnahmeelement 112. Der Behälter 102 kann gemäß des Verfahrens 100 hergestellt werden.

Diese Herstellung des Behälters 102, insbesondere das Fertigungs- und Montagekonzept, erfordert nur geringe Kosten. Weiterhin entsteht kein Zuliefer- und Logistik-Aufwand für die Herstellung des Oberteils 108 und des Unterteils 110 des Behälters 102.

Der Behälter 102 kann insbesondere elektronische Einheiten und Sensoren mit montierten elektronischen Modulen (bestückte Leiterplatten) umfassen und kann insbesondere in der Automobilindustrie verwendet werden.

### BEZUGSZEICHENLISTE

- 100: Verfahren
- 102: Behälter
- 108: Oberteil
- 110: Unterteil
- 112: Aufnahmeelement
- 114: Erstellen
- 115: Bearbeitungsvorrichtung
- 115a: Bearbeitungsbereich
- 115b: Bearbeitungsbereich
- 115c: Tiefziehwerkzeug
- 115d: Tiefziehwerkzeug
- 116: Erstellen
- 117: Pin
- 118: Führen
- 119a: Befestigungsteil
- 119b: Befestigungsteil
- 119c: Klipsen
- 120: Aufnehmen
- 120a: Kontaktieren
- 120b: Prüfen
- 121: Ausstanzen
- 122: Führen
- 124: Zusammenfügen
- 200: Edukt
- 200a: Rolle
- 202: Edukt
- 202a: Rolle

## Patentansprüche

1. Verfahren (100) zur Herstellung eines Behälters (102) mit einem Oberteil (108), einem Unterteil (110) und einem Aufnahmeelement (112), zumindest aufweisend die folgenden Schritte:
Erstellen (114) des Unterteils (110) aus einem ersten Edukt (200) in einem ersten Bearbeitungsbereich (115a) einer Bearbeitungsvorrichtung (115);
Erstellen (116) des Oberteils (108) aus einem zweiten Edukt (202) in einem zweiten Bearbeitungsbereich (115b) der Bearbeitungsvorrichtung (115);
Führen (118) des Aufnahmeelements (112) in den ersten Bearbeitungsbereich (115a) der Bearbeitungsvorrichtung (115);
Aufnehmen (120) des Aufnahmeelements (112) durch das Unterteil (110) in dem ersten Bearbeitungsbereich (115a) der Bearbeitungsvorrichtung (115);
Führen (122) des Oberteils (108) von dem zweiten Bearbeitungsbereich (115b) der Bearbeitungsvorrichtung (115) in den ersten Bearbeitungsbereich (115a) der Bearbeitungsvorrichtung (115); und
Zusammenfügen (124) von dem Oberteil (108) und dem Unterteil (110) zu dem Behälter (102) in dem ersten Bearbeitungsbereich (115a) der Bearbeitungsvorrichtung (115),
**dadurch gekennzeichnet, dass**
das Aufnahmeelement (112) ein elektrisches aktives Element ist, wobei das Verfahren ferner den Schritt des elektrischen Kontaktierens (120a) des durch das Unterteil (110) aufgenommenen Aufnahmeelements (112) aufweist.

2. Verfahren (100) nach Anspruch 1, wobei das Erstellen (114) des Unterteils (110) aus einem ersten Edukt (200) und/oder das Erstellen (116) des Oberteils (108) aus einem zweiten Edukt (202) durch Umformen des ersten Edukts (200) und/oder des zweiten Edukts (202) erfolgt.

3. Verfahren (100) nach Anspruch 2, wobei das Umformen ein Tiefziehen umfasst.

4. Verfahren (100) nach Anspruch 3, wobei das Umformen ein Abrollen des in aufgerollter Form bereitgestellten ersten Edukts (200) und/oder zweiten Edukts (202) umfasst.

5. Verfahren (100) nach Anspruch 1, wobei das Erstellen (114) des Unterteils (110) aus einem ersten Edukt (200) und/oder das Erstellen (116) des Oberteils (108) aus einem zweiten Edukt (202) durch Stanzen erfolgt.

6. Verfahren (100) nach mindestens einem der vorherigen Ansprüche, wobei das Aufnahmeelement (112) eine bestückte Leiterplatte.

7. Verfahren (100) nach zumindest einem der vorhergehenden Ansprüche, ferner aufweisend den Schritt des elektrischen Prüfens (120b) der Funktionsfähigkeit des elektrisch kontaktierten Aufnahmeelements (112).

8. Verfahren (100) nach mindestens einem der vorherigen Ansprüche, ferner aufweisend den Schritt des Bereitstellens von Kunststoff als erstes Edukt (200) und/oder als zweites Edukt (202) .

9. Verfahren (100) nach mindestens einem der vorherigen Ansprüche, wobei das erste Edukt (200) dem zweiten Edukt (202) entspricht.

10. Verfahren (100) nach mindestens einem der vorherigen Ansprüche, wobei das Erstellen (116) des Oberteils (108) in dem zweiten Bearbeitungsbereich (115b) der Bearbeitungsvorrichtung (115) in unmittelbarer Umgebung, insbesondere angrenzend, zu dem Erstellen (114) des Unterteils (110) in dem ersten Bearbeitungsbereich (115a) der Bearbeitungsvorrichtung (115) erfolgt.

11. Verfahren (100) nach mindestens einem der vorherigen Ansprüche, wobei das Führen (118) des Oberteils (108) von dem zweiten Bearbeitungsbereich (115b) in den ersten Bearbeitungsbereich (115a) automatisiert durchgeführt wird.

12. Verfahren (100) nach mindestens einem der vorherigen Ansprüche, wobei das Aufnehmen (120) des Aufnahmeelements (112) durch das Unterteil (110) in dem ersten Bearbeitungsbereich (115a) der Bearbeitungsvorrichtung (115) vor dem Zusammenfügen (124) von dem Oberteil (108) und dem Unterteil (110) zu dem Behälter (102) in dem ersten Bearbeitungsbereich (115a) der Bearbeitungsvorrichtung (115) durchgeführt wird.

13. Verfahren (100) nach mindestens einem der vorherigen Ansprüche, wobei das Aufnehmen (120) des Aufnahmeelements (112) durch das Unterteil (110) durch Verschrauben und/oder durch Warmverformung eines Verbindungselements erfolgt.

## Claims

1. Method (100) for producing a container (102) having a top part (108), a bottom part (110) and a receiving element (112), at least comprising the following steps:
the bottom part (110) is created (114) from a first starting material (200) in a first processing region (115a) of a processing apparatus (115);
the top part (108) is created (116) from a second starting material (202) in a second processing region (115b) of the processing apparatus (115);
the receiving element (112) is guided (118) into the first processing region (115a) of the processing apparatus (115);
the receiving element (112) is received (120) by the bottom part (110) in the first processing region (115a) of the processing apparatus (115);
the top part (108) is guided (122) from the second processing region (115b) of the processing apparatus (115) into the first processing region (115a) of the processing apparatus (115); and the top part (108) and the bottom part (110) are joined (124) to form the container (102) in the first processing region (115a) of the processing apparatus (115),
**characterized in that**
the receiving element (112) is an electrically active element, wherein the method further comprises the step of electrical contact being made (120a) with the receiving element (112) which is received by the bottom part (110).

2. Method (100) according to Claim 1, wherein the bottom part (110) is created (114) from a first starting material (200) and/or the top part (108) is created (116) from a second starting material (202) by reshaping the first starting material (200) and/or the second starting material (202).

3. Method (100) according to Claim 2, wherein the reshaping comprises thermoforming or deep-drawing.

4. Method (100) according to Claim 3, wherein the reshaping comprises unrolling the first starting material (200) and/or second starting material (202) which are/is provided in rolled-up form.

5. Method (100) according to Claim 1, wherein the bottom part (110) is created (114) from a first starting material (200) and/or the top part (108) is created (116) from a second starting material (202) by stamping.

6. Method (100) according to at least one of the preceding claims, wherein the receiving element (112) is a populated printed circuit board.

7. Method (100) according to at least one of the preceding claims, further comprising the step of the functional capability of the receiving element (112) with which electrical contact is made being electrically checked (120b).

8. Method (100) according to at least one of the preceding claims, further comprising the step of plastic being provided as the first starting material (200) and/or as the second starting material (202).

9. Method (100) according to at least one of the preceding claims, wherein the first starting material (200) corresponds to the second starting material (202).

10. Method (100) according to at least one of the preceding claims, wherein the top part (108) is created (116) in the second processing region (115b) of the processing apparatus (115) in direct proximity to, in particular adjoining, the bottom part (110) being created (114) in the first processing region (115a) of the processing apparatus (115).

11. Method (100) according to at least one of the preceding claims, wherein the top part (108) is guided (118) in an automated manner from the second processing region (115b) into the first processing region (115a).

12. Method (100) according to at least one of the preceding claims, wherein the receiving element (112) is received (120) by the bottom part (110) in the first processing region (115a) of the processing apparatus (115) before the top part (108) and the bottom part (110) are joined (124) to form the container (102) in the first processing region (115a) of the processing apparatus (115).

13. Method (100) according to at least one of the preceding claims, wherein the receiving element (112) is received (120) by the bottom part (110) by screw-connection and/or by hot deformation of a connecting element.

## Revendications

1. Procédé (100) de production d'un récipient (102) comprenant une partie supérieure (108), une partie inférieure (110) et un élément de réception (112), ledit procédé comprenant au moins les étapes suivantes :
réalisation (114) de la partie inférieure (110) à partir d'un premier éduit (200) dans une première zone de traitement (115a) d'un dispositif de traitement (115) ;
réalisation (116) de la partie supérieure (108) à partir d'un deuxième éduit (202) dans une deuxième zone de traitement (115b) du dispositif de traitement (115) ;
guidage (118) de l'élément de réception (112) dans la première zone de traitement (115a) du dispositif de traitement (115) ;
réception (120) de l'élément de réception (112) par la partie inférieure (110) dans la première zone de traitement (115a) du dispositif de traitement (115) ;
guidage (122) de la partie supérieure (108) depuis la deuxième zone de traitement (115b) du dispositif de traitement (115) jusque dans la première zone de traitement (115a) du dispositif de traitement (115) ; et
assemblage (124) de la partie supérieure (108) et de la partie inférieure (110) pour former le récipient (102) dans la première zone de traitement (115a) du dispositif de traitement (115),
**caractérisé en ce que**
l'élément de réception (112) est un élément électriquement actif, le procédé comprenant en outre l'étape de mise en contact électrique (120a) de l'élément de réception (112) reçu par la partie inférieure (110).

2. Procédé (100) selon la revendication 1, la réalisation (114) de la partie inférieure (110) à partir d'un premier éduit (200) et/ou la réalisation (116) de la partie supérieure (108) à partir d'un deuxième éduit (202) étant effectuées par formage du premier éduit (200) et/ou du deuxième éduit (202).

3. Procédé (100) selon la revendication 2, le formage comprenant un emboutissage profond.

4. Procédé (100) selon la revendication 3, le formage comprenant le déroulement du premier éduit (200) et/ou du deuxième éduit (202) prévus sous forme enroulée.

5. Procédé (100) selon la revendication 1, la réalisation (114) de la partie inférieure (110) à partir d'un premier éduit (200) et/ou la réalisation (116) de la partie supérieure (108) à partir d'un deuxième éduit (202) étant effectuées par estampage.

6. Procédé (100) selon l'une au moins des revendications précédentes, l'élément de réception (112) étant une carte de circuit imprimé équipée.

7. Procédé (100) selon l'une au moins des revendications précédentes, comprenant en outre l'étape de test électrique (120b) de la fonctionnalité de l'élément de réception (112) contacté électriquement.

8. Procédé (100) selon l'une au moins des revendications précédentes, comprenant en outre l'étape de fourniture de matière synthétique comme premier éduit (200) et/ou comme deuxième éduit (202).

9. Procédé (100) selon l'une au moins des revendications précédentes, le premier éduit (200) correspondant au deuxième éduit (202).

10. Procédé (100) selon l'une au moins des revendications précédentes, la réalisation (116) de la partie supérieure (108) dans la deuxième zone de traitement (115b) du dispositif de traitement (115) étant effectuée dans l'environnement immédiat de la réalisation (114), notamment de manière adjacente à celle-ci, de la partie inférieure (110) dans la première zone de traitement (115a) du dispositif d'usinage (115) .

11. Procédé (100) selon l'une au moins des revendications précédentes, le guidage (118) de la partie supérieure (108) depuis la deuxième zone de traitement (115b) jusque dans la première zone de traitement (115a) étant effectué automatiquement.

12. Procédé (100) selon l'une au moins des revendications précédentes, la réception (120) de l'élément de réception (112) par la partie inférieure (110) dans la première zone de traitement (115a) du dispositif de traitement (115) étant effectuée avant l'assemblage (124) de la partie supérieure (108) et de la partie inférieure (110) pour obtenir le récipient (102) dans la première zone de traitement (115a) du dispositif de traitement (115).

13. Procédé (100) selon l'une au moins des revendications précédentes, la réception (120) de l'élément de réception (112) par la partie inférieure (110) étant effectuée par vissage et/ou par déformation à chaud d'un élément de liaison.
